# EUROPEAN PATENT APPLICATION

(11) **EP 4 394 902 A1**
(43) Date of publication of application: **03.07.2024**
(21) Application number: 22861352.7
(22) Date of filing: 23.08.2022
(51) Int. Cl.: H01L 33/32, H01L 33/40

(54) **REFLECTING ELECTRODE FOR LIGHT EMITTING ELEMENT**

(30) Priority: 25.08.2021 JP 2021136988
(71) Applicant: Idemitsu Kosan Co.,Ltd., Tokyo 100-8321 (JP); National University Corporation Tokai National Higher Education and Research System, Nagoya-shi, Aichi 464-8601 (JP)
(72) Inventor: TOMAI, Shigekazu, Tokyo 100-8321 (JP); KATSUMATA, Satoshi, Tokyo 100-8321 (JP); OYAMA, Masashi, Tokyo 100-8321 (JP); NAGATA, Kengo, Kiyosu-shi, Aichi 452-8564 (JP); MATSUBARA, Taichi, Nagoya-shi, Aichi 464-8601 (JP); KUSHIMOTO, Maki, Nagoya-shi, Aichi 464-8601 (JP); HONDA, Yoshio, Nagoya-shi, Aichi 464-8601 (JP); AMANO, Hiroshi, Nagoya-shi, Aichi 464-8601 (JP)
(74) Representative: Gille Hrabal Partnerschaftsgesellschaft mbB Patentanwälte
(86) International application number: PCT/JP2022/031704
(87) International publication number: WO 2023/027064

(57) **Abstract**

A stacked body comprising a reflective electrode layer (17), an intermediate layer (16) having a MgZnO composition, and a semiconductor layer (15) having an AlGaN composition in this order.

## Description

### Technical Field

The present invention relates to a stacked body suitable for a reflective electrode for an emitting device. More specifically, the present invention relates to a stacked body capable of increasing light extraction efficiency of an emitting device having an emitting wavelength in a deep ultraviolet range.

### Background Art

In an ultraviolet emitting device (LED), light having a short wavelength can be generated by adjusting the composition of a semiconductor that form an emitting layer. For example, when an AlGaN semiconductor is used, an LED can emit in a wavelength range of 210 nm to 365 nm (a range from ultraviolet to deep ultraviolet) by adjusting the composition ratio of Al.

In order to increase the efficiency of the UV-LED, it is required to efficiently extract the light generated in the emitting layer to the outside of the LED. For example, it is conceivable to use a conductive film having a high light transmittance in a desired wavelength range for the electrode on the light extraction side. Further, it is conceivable to use an electrode that reflects light in a desired wavelength range with a high reflectance on the electrode on the opposite side of the light extraction side.

For example, Patent Document 1 discloses a nitride-semiconductor ultraviolet emitting device in which a composition of a AlGaN layer is modulated from a high Al composition to a low Al composition, whereby both carrier injection into an emitting layer and improvement in light extraction efficiency are achieved. In the emitting device, a stacked body of a Pd thin film and a thick metal film such as Al or Ag is used as the reflective electrode.

### Related Art Document

### Patent Document

[Patent Document 1] JP 2013-120829 A

### Summary of the Invention

However, in order to increase the output of the emitting device, it is required to further increase the light extraction efficiency.

An object of the present invention is to provide a stacked body capable of increasing light extraction efficiency of an emitting device having an emitting wavelength in a deep ultraviolet range, a method of producing the stacked body, and an emitting device.

As a result of intensive studies, the present inventors have found that a stacked body having a reflective electrode layer, an intermediate layer having a MgZnO composition, and a semiconductor layer having an AlGaN composition in this order can increase light extraction efficiency of an emitting device having an emitting wavelength in a deep ultraviolet range, and have completed the present invention.

According to the present invention, the following stacked body and so on can be provided.
1. A stacked body comprising a reflective electrode layer, an intermediate layer having a MgZnO composition, and a semiconductor layer having an AlGaN composition in this order.
2. The stacked body according to 1, wherein the reflective electrode layer comprises at least one metal selected from the group consisting of Al, Rh, Mo, W, and Cr.
3. The stacked body according to 1 or 2, wherein the intermediate layer comprises an oxide of magnesium and an oxide of zinc.
4. The stacked body according to any one of 1 to 3, wherein the intermediate layer has a MgZnO composition of MgₓZn_{y}O (x is 0.2 to 0.8, y is 0.8 to 0.2).
5. The stacked body according to any one of 1 to 4, wherein the thickness of the intermediate layer is 1 to 80 nm.
6. A method of producing the stacked body according to any of 1 to 5, comprising: forming the intermediate layer on the semiconductor layer.
7. The method of producing according to 6, wherein the intermediate layer is formed by sputtering, molecular beam epitaxy (MBE) method, vacuum-deposition, or ion plating.
8. The method of producing according to 6 or 7, wherein the surface temperature of the semiconductor layer at the time of forming the intermediate layer is 20°C or higher and 600°C or lower.
9. The method of producing according to any one of 6 to 8, wherein the surface temperature of the semiconductor layer at the time of forming the intermediate layer is 180°C or higher and 300°C or lower.
10. The method of producing according to any one of 6 to 9, comprising heat-treating the formed intermediate layer at the temperature of 600°C or higher.
11. An emitting device comprising the stacked body according to any one of 1 to 5.
12. The emitting device according to 11, comprising
   a stacked structure having a substrate, an n-type contact layer, an emitting layer, and the stacked body in this order, and
   an electrode layer formed on a part of the n-type contact layer on which the emitting layer is not formed.
13. The emitting device according to 11, comprising
   a stacked structure having a substrate, an n-type contact layer, an emitting layer, a p-type semiconductor layer, and an electrode layer in this order, and
   an intermediate layer having a MgZnO composition and a reflective electrode layer on a part of the n-type contact layer on which the emitting layer is not formed in this order, wherein the part of the n-type contact layer, the intermediate layer having a MgZnO composition, and the reflective electrode layer form the stacked body.
14. The emitting device according to 11, comprising
   a stacked structure having a substrate, an n-type contact layer, an emitting layer, and the stacked body in this order, and
   an intermediate layer having a MgZnO composition and a reflective electrode layer on a part of the n-type contact layer on which the emitting layer is not formed in this order, wherein the part of the n-type contact layer, the intermediate layer having a MgZnO composition, and the reflective electrode layer form the stacked body.
15. The emitting device according to any one of 12 to 14, comprising a p-type semiconductor layer between the emitting layer and the stacked body, wherein the p-type semiconductor layer and the semiconductor layer of the stacked body form a tunnel junction structure.

According to the present invention, it is possible to provide a stacked body capable of increasing light extraction efficiency of an emitting device having an emitting wavelength in a deep ultraviolet range, a method of producing the stacked body, and an emitting device.

### Brief Description of the Drawings

Figure 1 is a diagram for explaining an example of a layer configuration of the emitting device according to an aspect of the present invention.
Figure 2 is a diagram for explaining another example of a layer configuration of the emitting device according to an aspect of the present invention.
Figure 3 is a diagram for explaining another example of a layer configuration of the emitting device according to an aspect of the present invention.
Figure 4 is a diagram for explaining another example of a layer configuration of the emitting device according to an aspect of the present invention.
Figure 5 is a diagram for explaining a layer configuration of an emitting device produced in Example.

### Mode for Carrying out the Invention

Hereinafter, a stacked body, a method of producing the stacked body, and an emitting device of the present invention will be described in detail.

In this specification, "x to y" represents a numerical range of "x or more and y or less." The upper and lower limits stated for the numerical value range can be combined arbitrarily.

### [Stacked body]

The stacked body according to an aspect of the present invention has a reflective electrode layer, an intermediate layer having a MgZnO composition, and a semiconductor layer having an AlGaN composition in this order. In this aspect, by providing the intermediate layer, it is possible to suppress deterioration of the surface of aluminum or the like forming the reflective electrode layer due to annealing. As a result, the specular surface of the reflective electrode layer can be maintained, and thus the light extraction efficiency of the emitting device can be increased. In addition, by providing a semiconductor layer having an AlGaN composition in contact with the intermediate layer, it is possible to easily inject holes from the reflective electrode layer into the semiconductor layer or the like forming the emitting device.

Hereinafter, each constituent layer will be described.

### · Reflective electrode layer

As the reflective electrode layer, a layer made of a metal capable of reflecting deep ultraviolet rays, a dielectric multilayer film, or the like can be used. The reflective electrode layer preferably has a layer made of a metal capable of reflecting deep ultraviolet rays. Examples of the metal capable of reflecting deep ultraviolet rays include metals such as Al, Pt, Ni, Au, Rh, Mo, W, Cr, and alloys of these metals. Among these, Al, Rh, Mo, W, or Cr is preferable, and Al is more preferable because of its excellent reflection of deep ultraviolet rays. Nd, Ni, or the like may be added to Al.

In one embodiment, 70% by mass or more, 80% by mass or more, 90% by mass or more, 95% by mass or more, 97% by mass or more, 99% by mass or more, 99.5% by mass or more, or substantially 100% by mass of the reflective electrode layer is Al. In the case of "substantially 100% by mass," inevitable impurities may be contained in the reflective electrode layer.

The thickness of the reflective electrode layer is not particularly limited, and is, for example, 200 nm or more, 100 nm or more, or 50 nm or more, and 2000 nm or less, 1000 nm or less, or 500 nm or less.

The reflective electrode layer may be a single layer or a stacked body of two or more layers.

### · Intermediate layer

The intermediate layer has a MgZnO composition. The MgZnO composition is preferably MgₓZn_{y}O (x is 0.2 to 0.8, y is 0.2 to 0.8). Here, the relationship of y=1-x may be satisfied or may not be satisfied.

The term "MgZnO composition" means that Mg, Zn, and O are contained as the constituent elements, and does not mean a solid solution of these three elements. The intermediate layer preferably contains an oxide of magnesium (MgO or the like) and an oxide of zinc (ZnO or the like) as the MgZnO composition. In addition to the oxide of magnesium and oxide of zinc, a solid solution of Mg, Zn, and O may or may not be contained in the MgZnO composition.

In the intermediate layer, it is preferable that a region composed mainly of an oxide of magnesium and a region composed mainly of an oxide of zinc are dispersed in a surface direction (a direction intersecting the thickness direction) of the layer. As a result, the region composed mainly of an oxide of magnesium exhibits excellent deep ultraviolet transmittance, and the region composed mainly of an oxide of zinc exhibits excellent conductivity. This phenomenon can be explained by the percolation conduction model. The presence of the region composed mainly of an oxide of magnesium and the region composed mainly of an oxide of zinc can be confirmed by transmission electron microscopy (TEM) images and energy dispersive X-ray spectroscopy (EDX) images of the cross section of the intermediate layer.

The intermediate layer may or may not contain a trivalent or tetravalent element X other than Mg and Zn. When the element X is contained, the molar ratio of the element X based on all metal elements [element X/all metal elements] is preferably 0.0001 or more and 0.20 or less, and more preferably 0.001 or more and 0.10 or less. Examples of the element X include B, Al, Ga, In, TI, C, Si, Ge, Sn, and Pb. Preferably, the element X is B, Al, or Ga.

The thickness of the intermediate layer is not particularly limited. When the thickness of the intermediate layer is 80 nm or less, 60 nm or less, or 50 nm or less, the absorption of deep ultraviolet rays by the intermediate layer is suppressed, and the extraction efficiency of deep ultraviolet rays from the emitting device can be further increased. When the thickness of the intermediate layer is 1 nm or more, 5 nm or more, or even 15 nm or more, the conductivity of the intermediate layer can be increased. In these viewpoints, the thickness of the intermediate layer is preferably 1 to 80 nm, 5 to 60 nm, or even 15 to 50 nm.

The thickness of the intermediate layer can be measured by observing the cross-section using a transmission electron microscope (TEM).

The intermediate layer can be formed by sputtering, molecular beam epitaxy (MBE) method, vacuum deposition, ion plating, or the like.

For example, when the intermediate layer is formed by sputtering, the composition of the intermediate layer can be controlled by adjusting the composition of the sputtering target. It can also be controlled by co-sputtering with a sintered target of the oxide of magnesium and a sintered target of oxide of zinc, and an optional sintered target containing an element X, while controlling the respective deposition rates. As for other film forming methods, the composition of the intermediate layer can be controlled by adjusting the composition of raw materials such as vapor deposition sources.

In the case of forming the intermediate layer by sputtering or vapor deposition, the composition of the intermediate layer substantially coincides with the composition of the sputtering target and the composition of the deposition source.

The molar ratio of each element of the intermediate layer (e.g., x and y in MgₓZn_{y}O described above) can be measured, for example, by secondary ion mass spectrometry.

The intermediate layer can be formed, for example, by forming a film on a semiconductor layer having an AlGaN composition.

The surface temperature of the semiconductor layer at the time of forming the intermediate layer (for example, during sputtering) is not particularly limited, and is, for example, 20°C or higher, 40°C or higher, 60°C or higher, 80°C or higher, 100°C or higher, 120°C or higher, 140°C or higher, 160°C or higher, 170°C or higher, or 180°C or higher. When this temperature is higher, in particular, the temperature is 180°C or higher, the transmittance of deep ultraviolet rays in the intermediate layer can be suitably increased. The upper limit is not particularly limited, and is, for example, preferably 600°C or lower, and more preferably 300°C or lower.

The formed intermediate layer is preferably subjected to a heat treatment. The treatment temperature is preferably 600°C or higher, more preferably 650°C or higher, and particularly preferably 700°C or higher. It is considered that the heat treatment causes aggregation, separation, and the like of the oxide, and as a result, the oxide of zinc forms a network, thereby favorably exhibiting conductivity, while the oxide of magnesium aggregates in the gaps in the network of the oxide of zinc, thereby favorably increasing the transmittance of deep ultraviolet rays. The upper limit of the temperature of the heat treatment is not particularly limited, and is, for example, 1200°C or lower.

### · Semiconductor layer having an AlGaN composition

The semiconductor layer has an AlGaN composition. The AlGaN composition is preferably higher in Al composition from the viewpoint of light extraction. On the other hand, from the viewpoint of the carrier tunneling probabilities, it is preferable that Al composition is lower because a tunnel junction layer is formed. The AlGaN composition may be, for example, Al_{g}Ga_{1-g}N (g is 0.3 to 0.8, may be 0.4 to 0.7, an is preferably 0.5 to 0.65).

The semiconductor layer may be an n-type semiconductor, also may be a p-type semiconductor. It can be appropriately selected in accordance with a layer connected to the surface opposite to the intermediate layer side (for example, a constituent layer of an emitting device). Preferably, the semiconductor layer is an n-type semiconductor.

The thickness of the semiconductor layer is, for example, 10 nm or more, 20 nm or more, or 50 nm or more, and 1000 nm or less, 500 nm or less, or 100 nm or less.

The stacked body of this aspect can be produced, for example, by forming an intermediate layer on a semiconductor layer and further forming a reflective electrode layer. The constituent layers can be formed by sputtering, MBE (molecular beam epitaxy) method, metalorganic vapor phase epitaxy (MOVPE) vacuum deposition, ion plating, or the like.

### [Emitting device]

The emitting device according to an aspect of the present invention may have the above-described stacked body of the present invention. The layer configuration is not limited as long as the configuration emits deep ultraviolet rays, and any known configuration can be adopted.

Hereinafter, an example of an emitting device using the stacked body of the present invention will be described with reference to the drawings.

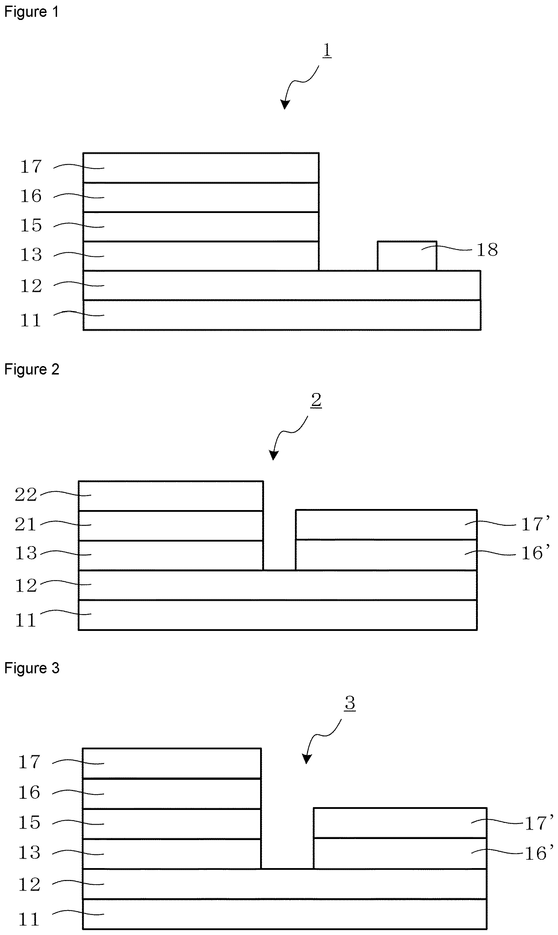

Figure 1 is a diagram for explaining an example of a layer configuration of the emitting device according to this aspect.

The emitting device 1 has a stacked structure having a substrate 11, an n-type contact layer 12 (which may be referred to as an n-type nitride semiconductor layer or an electron-transporting layer), an emitting layer 13 (which may be referred to as an active layer), a p-type semiconductor layer 15, an intermediate layer 16, and a reflective electrode layer 17 in this order. An electrode layer 18 is formed on a part of the n-type contact layer on which the emitting layer 13 is not formed.

Here, the p-type semiconductor layer 15, the intermediate layer 16, and the reflective electrode layer 17 correspond to the stacked body according to the present invention described above.

In this aspect, holes are injected from the reflective electrode layer 17 and electrons are injected from the electrode layer 18, respectively, and holes and electrons are recombined in the emitting layer 13 to emit light. Of the light generated in the emitting layer 13, the light generated in the direction of the reflective electrode layer 17 is reflected by the reflective electrode layer 17 and is extracted from the substrate 11. In the emitting device 1, since the stacked body of the present invention is formed on the reflective electrode side, light extraction efficiency can be increased.

As a modification, a dielectric multilayer film using an insulator may be used as the reflective electrode layer to ensure high reflectance. In this case, the intermediate layer injects electrons and serves as a diffusion layer for electrons.

Figure 2 is a diagram for explaining another example of the layer configuration of the emitting device according to this aspect.

The emitting device 2 has a stacked structure (emitting portion) having a substrate 11, an n-type contact layer 12, an emitting layer 13, a p-type semiconductor layer 21, and an electrode layer 22 in this order. Further, the intermediate layer 16' and the reflective electrode layer 17' are provided in this order on a part of the n-type contact layer 12 on which the emitting layer 13 is not formed (electrode portion).

Here, the n-type contact layer 12, the intermediate layer 16', and the reflective electrode layer 17' correspond to the stacked body according to the present invention described above. In this aspect, the n-type contact layer 12 is an n-type semiconductor layer having an AlGaN composition.

As in the case of the emitting device 1, a high reflectance may be ensured by using a dielectric multilayer film using an insulator as the reflective electrode layer.

In this aspect, holes are injected from the electrode layer 22 and electrons are injected from the reflective electrode layer 17', respectively, and holes and electrons are recombined in the emitting layer 13 to emit light. Part of the light generated in the emitting layer 13 is multiple-reflected by the interface of each layer and the substrate, and enters the electrode portion. In this aspect, the light entering the electrode portion is reflected by the reflective electrode layer 17' and can be extracted from the substrate 11, so that the light extraction efficiency can be increased.

Figure 3 is a diagram for explaining another example of the layer configuration of the emitting device according to this aspect.

The emitting device 3 has a stacked structure (emitting portion) having a substrate 11, an n-type contact layer 12, an emitting layer 13, a p-type semiconductor layer 15, an intermediate layer 16, and a reflective electrode layer 17 in this order. Further, the intermediate layer 16' and the reflective electrode layer 17' are provided in this order on a part of the n-type contact layer 12 on which the emitting layer 13 is not formed (electrode portion).

Here, the stacked structure of the p-type semiconductor layer 15, the intermediate layer 16, and the reflective electrode layer 17 and the stacked structure of the n-type contact layer 12, the intermediate layer 16', and the reflective electrode layer 17' correspond to the stacked body according to the present invention described above. The emitting device of this aspect has two sets of stacked bodies.

The emitting device 3 has a structure in which the emitting device 1 and the emitting device 2 are combined. In this aspect, holes are injected from the reflective electrode layer 17 and electrons are injected from the reflective electrode layer 17' and holes and electrons are recombined in the emitting layer 13 to emit light. Of the light generated in the emitting layer 13, the light generated in the direction of the reflective electrode layer 17 is reflected by the reflective electrode layer 17 and is extracted from the substrate 11. Further, a part of the light generated in the emitting layer 13 is multiple-reflected by the interface of each layer and the substrate and enters the electrode portion, and in this aspect, the light entered the electrode portion is reflected by the reflective electrode layer 17' and is extracted from the substrate 11.

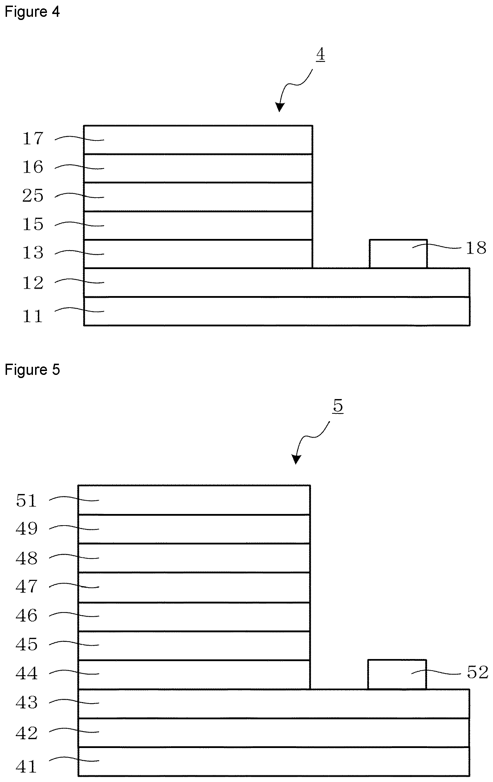

Figure 4 is a diagram for explaining another example of the layer configuration of the emitting device according to this aspect.

The emitting device 4 has the same configuration as the emitting device 1 except that the n-type semiconductor layer 25 is provided between the p-type semiconductor layer 15 and the intermediate layer 16.

Here, the n-type semiconductor layer 25, the intermediate layer 16, and the reflective electrode layer 17 correspond to the stacked body according to the present invention described above.

In the emitting device 4, a p-type semiconductor layer 15 is provided between the emitting layer 13 and the reflective electrode layer 17, and the p-type semiconductor layer 15 and the n-type semiconductor layer 25 of the stacked body form a tunnel junction structure. This increases the hole injection efficiency into the emitting layer.

In the emitting devices 2 and 3, a tunnel junction structure can be formed in the same manner.

In addition to the layers shown in Figures 1 to 4, the emitting device of this aspect may have a known layer. For example, a buffer layer may be provided between the substrate and the n-type contact layer. Further, an auxiliary electrode layer may be formed on the reflective electrode layer. Further, an electron blocking layer and/or a hole blocking layer may be formed in order to retain holes or electrons in the emitting layer. Each of the layers constituting the emitting device may be a single layer or a stacked structure of two or more layers.

Hereinafter, each constituent element will be described in detail by exemplifying the configuration of the emitting device produced in Examples of this application.

Figure 5 is a diagram for explaining a layer configuration of an emitting device produced in Example.

The emitting device 5 has a substrate 41, a buffer layer 42, an n-type contact layer 43, an emitting layer 44, an electron blocking layer 45, a p-type semiconductor layer 46, an n-type semiconductor layer 47, an intermediate layer 48, a reflective electrode layer 49, and an auxiliary electrode layer 51 in this order. In addition, the electrode layer 52 is stacked on a part of an area of the surface of the buffer layer 42 on the emitting layer 44 side where the emitting layer 44 is not provided.

Here, the n-type semiconductor layer 47, the intermediate layer 48, and the reflective electrode layer 49 correspond to the stacked body according to the present invention.

### (Substrate 41)

The substrate 41 may be made of a material capable of transmitting deep ultraviolet rays (360 nm or shorter). Examples of the material capable of transmitting deep ultraviolet rays include sapphire, AlGaN, AIN, InAlGaN, SiC, and the like. Among them, a sapphire substrate is preferable.

The crystal-growing surface of the substrate 41 is preferably a c-plane (0001) when the emitting wavelength is 260 nm or longer. When the emitting wavelength is 260 nm or shorter, a crystalline plane other than the c-plane may be used.

### (Buffer layer 42)

The buffer layer 42 has a stacked structure having a core layer, a first buffer layer, and a second buffer layer in this order on the substrate 41. Each layer has a AIN composition.

The thickness of the buffer layer is not particularly limited, and is, for example, 1000 nm or more, 1500 nm or more, or 2000 nm or more, and 5000 nm or less, 4500 nm or less, or 4000 nm or less.

### (n-type contact layer 43)

The n-type contact layer is an electron-transporting layer.

The n-type contact layer 43 has an AlGaN composition. The AlGaN composition is not particularly limited, and may be, for example, AlₐGa₁₋ₐN (a is 0.5 or more, 0.55 or more, or 0.6 or more, and is 0.95 or less, 0.9 or less, or 0.8 or less).

The n-type contact layer 43 is n-type doped. The dopant used for n-type doping is preferably Si when Al composition is 60% or more, and is preferably Ge when Al composition is 60% or less. The concentration of the dopant in the n-type contact layer 43 is 8×10¹⁸ cm⁻³ to 4×10¹⁹ cm⁻³, for example.

In the present application, "Al composition: %" means the ratio of Al atoms in the AlGaN composition [AI/(AI+Ga): atom%].

The thickness of the n-type contact layer 43 is not particularly limited, and is, for example, 500 nm or more, 700 nm or more, or 900 nm or more, and 4000 nm or less, 3000 nm or less, or 2000 nm or less.

### (Emitting layer 44)

The emitting layer 44 is an emitting layer that emits light in the ultraviolet range.

The emitting layer 44 have an AlGaN composition.

The emitting layer 44 may have a multi quantum well (MQW) structure. For example, the emitting layer 44 may have a plurality of well layers and a plurality of barrier layers having a larger bandgap than the well layers. Here, the plurality of well layers and the plurality of barrier layers may each have an Al_{b}Ga_{1-b}N composition (b is 0.35 or more, 0.5 or more, or 0.6 or more, and 0.5 or less, 0.7 or less, or 0.8 or less). This composition (value of b) may be the same or different for each layer.

The thickness of each of the well layers is, for example, 1 to 6 nm, and the thickness of each of the barrier layers is, for example, 3 to 15 nm.

The configuration of the emitting layer 44 is not limited thereto. For example, the emitting layer 44 may have no multiple quantum well structure. For example, the emitting layer 44 may have a single quantum well structure or may be formed of a single layer.

### (Electron-blocking layer 45)

The electron-blocking layer 45 have an AlGaN composition. The AlGaN composition is not particularly limited, and may be, for example, Al_{c}Ga_{1-c}N (c is 0.6 or more, 0.65 or more, or 0.7 or more, and is 0.95 or less, 0.9 or less, or 0.8 or less).

The electron-blocking layer 45 is doped with Mg. Mg concentration is, for example, 1×10¹⁸ cm⁻³ to 2×10²⁰ cm⁻³.

The thickness of the electron-blocking layer 45 is not particularly limited, and is, for example, 1 nm or more, 2 nm or more, or 5 nm or more, and 40 nm or less, 30 nm or less, or 25 nm or less.

### (p-type semiconductor layer 46)

The p-type semiconductor layer 46 is a hole-transporting layer.

The p-type semiconductor layer 46 has a first p-type semiconductor layer and a second p-type semiconductor layer in this order on the electron-blocking layer 4.

The first p-type semiconductor layer has an AlGaN composition. The AlGaN composition needs to be changed in Al composition depending on the emitting wavelength in order to suppress light absorption. Incidentally, the higher the Al composition, the lower the carrier concentration and the more the hole injection will be inhibited, so that Al composition is preferable as low as possible. For example, the AlGaN composition may be Al_{d}Ga_{1-d}N (d is 0.3 to 0.8, may be 0.4 to 0.7, and is preferably 0.5 to 0.65).

The first p-type semiconductor layer is p-type doped. Examples of the dopant used for p-type doping include Mg, Zn, Be, and the like. The concentration of the dopant in the first p-type semiconductor layer is, for example, 1×10¹⁹ to 1×10²⁰ cm⁻³.

The thickness of the first p-type semiconductor layer is, for example, 1 to 200 nm or 10 to 100 nm, preferably 40 to 60 nm, in order to have the function of blocking electrons.

The second p-type semiconductor layer has an AlGaN composition. From the viewpoint of light extraction, the AlGaN composition is preferably higher in the Al composition, as in the first p-type semiconductor layer. On the other hand, from the viewpoint of the carrier tunneling probabilities, the Al composition is preferable as low as possible. For example, the AlGaN composition may be AlₑGa₁₋ₑN (e is 0.3 to 0.8 or 0.4 to 0.7, and is preferably 0.5 to 0.65).

The second p-type semiconductor layer is p-type doped. Examples of the dopant used for p-type doping include Mg, Zn, Be, and the like. The concentration of the dopant in the second p-type semiconductor layer is, for example, 6×10¹⁹ to 4×10²⁰ cm⁻³. The concentration of the dopant in the second p-type semiconductor layer is preferably higher than the concentration of the dopant in the first p-type semiconductor layer in order to suitably form a tunneling junction to be described later.

The thickness of the second p-type semiconductor layer is not particularly limited, and is, for example, 1 nm or more, 2 nm or more, or 5 nm or more, and 200 nm or less, 150 nm or less, or 100 nm or less.

### (n-type semiconductor layer 47)

The n-type semiconductor layer 47 is a stacked body having a first n-type semiconductor layer and a second n-type semiconductor layer in this order on the p-type semiconductor layer 46.

The first n-type semiconductor layer has an AlGaN composition. As in the first p-type semiconductor layer and the second p-type semiconductor layer, Al composition is preferably as high as possible from the viewpoint of light extraction. On the other hand, it is preferable that Al composition is as low as possible from the viewpoint of the carrier tunneling probabilities. For example, the AlGaN composition may be Al_{f}Ga_{1-f}N (f is 0.3 to 0.8 or 0.4 to 0.7, and is preferably 0.5 to 0.65).

The first n-type semiconductor layer is n-type doped. Examples of the dopant used for n-type doping include Si, Ge, and the like. The concentration of the dopant in the first n-type semiconductor layer is, for example, 6×10¹⁹ to 4×10²⁰ cm⁻³. The concentration of the dopant in the first n-type semiconductor layer is preferably higher than the concentration of the dopant in the second n-type semiconductor layer in order to suitably form a tunneling junction to be described later.

The thickness of the first n-type semiconductor layer is not particularly limited, and is, for example, 1 nm or more, 2 nm or more, or 5 nm or more, and 200 nm or less, 100 nm or less, or 50 nm or less.

The second n-type semiconductor layer has an AlGaN composition. As in the AlGaN composition of the first p-type semiconductor layer and the second p type semiconductor layer, Al composition is preferably as high as possible from the viewpoint of light extraction. On the other hand, it is preferable that Al composition is as low as possible from the viewpoint of the carrier tunneling probabilities. For example, the AlGaN composition may be Al_{g}Ga_{1-g}N (g is 0.3 to 0.8 or 0.4 to 0.7, and is preferably 0.5 to 0.65).

The second n-type semiconductor layer is n-type doped. Examples of the dopant used for n-type doping include Si, Ge, and the like. The concentration of the dopant in the second n-type semiconductor layer is, for example, 8×10¹⁸ to 4×10¹⁹ cm⁻³.

The thickness of the second n-type semiconductor layer is, for example, 50 nm or more, 20 nm or more, or 10 nm or more, and 1000 nm or less, 500 nm or less, or 100 nm or less.

The total film thickness from the emitting layer 44 to the reflective electrode layer 49 is an integer multiple of λ/4 (λ is the emitting wavelength), whereby the light extraction efficiency can be increased. Since the second n-type semiconductor layer has lower resistivity than the other layers, it is preferable to adjust the film thickness by changing the film thickness of the second n-type semiconductor layer.

The method of forming the buffer layer 42, the n-type contact layer 43, the emitting layer 44, the electron-blocking layer 45, the p-type semiconductor layer 46, and the n-type semiconductor layer 47 is not particularly limited, and metalorganic vapor phase epitaxy (MOVPE) method and the like can be used.

### (Intermediate layer 48)

The intermediate layer 48 has a MgZnO composition. The MgZnO composition is preferably MgₓZn_{y}O (x is 0.2 to 0.8, y is 0.2 to 0.8). The description of the intermediate layer 48 is the same as the description of the intermediate layer of the stacked body described above.

### (Reflective electrode layer 49)

The reflective electrode layer 49 is an anode and is configured to reflect light from the intermediate layer 48 side to the intermediate layer 48 side. Here, the light from the intermediate layer 48 side may be light including deep ultraviolet rays emitted in the emitting layer 44. The description of the reflective electrode layer 49 is the same as the description of the reflective electrode layer of the stacked body described above.

In this aspect, the auxiliary electrode layer 51 is formed on the reflective electrode layer 49.

The auxiliary electrode layer 51 may be made of a conductive material. Examples of the conductive material include a metal and the like. Examples of the metal include one metal or an alloy of two or more metals selected from the group consisting of V, Al, Ti, Pt, and Au. For example, when Al is used as the reflective electrode layer, adhesion to the pad electrode is increased by using Ti as the auxiliary electrode layer.

The auxiliary electrode layer 51 may be a single layer or a stacked structure of two or more layers.

The thickness of the auxiliary electrode layer 51 is not particularly limited, and is, for example, 0.5 to 10 nm, and is preferably 1 to 5 nm.

### (Electrode layer 52)

The electrode layer 52 is a cathode that is connected to a pad electrode.

The electrode layer 52 may be formed of a conductive material. Examples of the conductive material include a metal and the like. Examples of the metal include one metal or an alloy of two or more metals selected from the group consisting of V, Al, Ti, Pt, Au, In, and Sn.

The electrode layer 52 may be a single layer or a stacked structure of two or more layers.

The thickness (total thickness) of the electrode layer 52 is not particularly limited, and is desirably, for example, 100 to 1000 nm, and preferably 100 to 500 nm.

The method of forming the reflective electrode layer 49, the auxiliary electrode layer 51, and the electrode layer 52 is not particularly limited, and for example, vapor deposition can be used.

In the emitting device of this aspect, the p-type semiconductor layer 46 and the n-type semiconductor layer 47 stacked on the p-type semiconductor layer 46 are tunnel junctioned (tunnel junction structure). As a result, since the potential barrier is very thin, electrons and holes pass through the potential barrier, and the hole injection efficiency into the emitting layer 44 can be increased.

An intermediate layer 48 having a small work function can be preferably provided on the n-type semiconductor layer 47.

Furthermore, since the intermediate layer 48 is provided on the n-type semiconductor layer 47, the reflective electrode layer 49 containing a metal capable of reflecting deep ultraviolet rays (also referred to as "deep ultraviolet reflecting metal") can be suitably provided. That is, when the reflective electrode layer 49 is directly provided on the n-type semiconductor layer 47, the surface smoothness of the reflective electrode layer 49 is lost when annealing is performed in order to lower the contact resistance, and specular reflection by the deep ultraviolet reflecting metal becomes difficult. On the other hand, when the intermediate layer 48 is provided, the surface smoothness of the reflective electrode layer 49 is maintained when annealed by the intermediate layer 48, and the specular reflection by the deep ultraviolet reflective metal is stably maintained. The reflective electrode layer 49 can efficiently reflect deep ultraviolet rays through specular reflection by a deep ultraviolet reflecting metal.

When holes and electrons recombine in the emitting layer 44, deep ultraviolet rays are emitted from the emitting layer 44. The deep ultraviolet rays emitted from the emitting layer 44 toward the substrate 41 side are transmitted through the substrate 41 and emitted to the outside of the emitting device. At the same time, the deep ultraviolet rays emitted from the emitting layer 44 toward the reflective electrode layer 49 side are efficiently reflected by the reflective electrode layer 49, transmitted through the substrate 41, and emitted to the outside of the emitting device. As a result, the light extraction efficiency of the emitting device having the emitting wavelength in the deep ultraviolet range can be increased.

When ITO (Indium Tin Oxide) is used in place of the intermediate layer 48 having an MgZnO composition, the film must be formed extremely thin because ITO tends to absorb deep ultraviolet rays. In this case, the problem arises that ITO cannot prevent surface degradation of Al during the annealing process.

The configuration of the emitting device is not limited to that described above. The emitting device according to an aspect of the present invention has a stacked body according to an aspect of the present invention, and an emitting layer provided on the n-type semiconductor layer side in the stacked body and having an AlGaN composition.

In one embodiment, a p-type semiconductor layer having an AlGaN composition is provided between the n-type semiconductor layer and the emitting layer.

In one embodiment, the n-type semiconductor layer and the p-type semiconductor layer are tunnel junctioned.

The emitting device according to this aspect has an emitting wavelength in the deep ultraviolet range. Specifically, the emitting device has an emitting wavelength in the range of 200 to 350 nm, preferably in the range of 210 to 310 nm, more preferably in the range of 220 to 290 nm.

The application of the emitting device is not particularly limited, and can be widely used in various fields. For example, the emitting device can be used for sterilization, virus inactivation, detection device, skin medicine, resin curing light source, and the like.

### Examples

Examples of the present invention will be described below, and the present invention is not limited to these Examples.

### (Examples 1 to 6)

An emitting device having a layer configuration similar to that of Figure 5 was produced by the following method.

A buffer layer 42, an n-type contact layer 43, an emitting layer 44, an electron-blocking layer 45, a p-type semiconductor layer 46, and an n-type semiconductor layer 47 were deposited in this order on a c-plane (0001) of a sapphire substrate (thickness: 200 µm) as the substrate 41 by a metalorganic vapor phase epitaxy (MOVPE) method. Table 1 shows the configuration of each of these layers (and each of the layers described later).

For example, trimethylgallium, trimethylaluminum, and ammonia were used for Ga source gas, Al source gas, and N source gas, respectively, to form each of the layers of the emitting device. For example, silane gas and bis(cyclopentadienyl)magnesium gas were used for Si source gas as an n-type dopant and Mg source gas as a p-type dopant, respectively. For example, hydrogen gas or nitrogen gas was used as a carrier gas.

A substrate 41 was prepared, and a buffer layer 42 was formed thereon. In forming the buffer layer 42, first, a core layer made of AlN was formed by MOCVD method. The growth temperature is, for example, 880°C. Next, a low-temperature (first) buffer layer and a high-temperature (second) buffer layer made of AlN were sequentially formed on the core layer. For example, the growth conditions for the low-temperature buffer layer are 1090°C for the growth temperature and 50 mbar for the growth pressure. For example, the growth conditions for the high-temperature buffer layer are 1270°C for the growth temperature and 50 mbar for the growth pressure.

Next, an n-type contact layer 43 made of an AlGaN containing Si was formed on the buffer layer 42 by MOVPE method. For example, the growth conditions for the n-type contact layer 43 are 980°C for the growth temperature and 50 to 150 mbar for the growth pressure.

Next, an emitting layer 44 was formed on the n-type contact layer 43 by MOVPE method. The emitting layer 44 was formed by stacking a first barrier layer, a first well layer, a second barrier layer, a second well layer, and a third barrier layer in this order. For example, the growth conditions for the emitting layer 44 are 975°C for the growth temperature and 400 mbar for the growth pressure.

Next, an electron-blocking layer 45 was formed on the emitting layer 44 by MOCVD method. For example, the growth conditions of the electron-blocking layer 45 are 975°C for the growth temperature and 400 mbar for the growth pressure.

Next, a p-type semiconductor layer 46 was formed on the electron-blocking layer 45 by MOCVD method. For example, the growth conditions of the p-type semiconductor layer 46 are 975°C for the growth temperature and 400 mbar for the growth pressure.

Next, an n-type semiconductor layer 47 was formed on the p-type semiconductor layer 46 by MOCVD method. For example, the growth conditions of the n-type semiconductor layer 47 are 980°C for the growth temperature and 50 to 150 mbar for the growth pressure.

Next, a predetermined area on the surface of the n-type semiconductor layer 47 was dryetched to form a groove having a depth up to the n-type contact layer 43.

Next, an intermediate layer 48 and a reflective electrode layer 49 were formed on the n-type semiconductor layer 47. Further, an auxiliary electrode layer 51 was formed on the reflective electrode layer 49. On the other hand, an electrode layer 52 was formed on the n-type contact layer 43 exposed on the bottom surface of the groove.

The intermediate layer 48, the reflective electrode layer 49, the auxiliary electrode layer 51, and the electrode layer 52 were formed by sputtering, vapor deposition, or the like.

Specifically, the substrate 41 on which up to the n-type semiconductor layer 47 was formed was placed in a sputtering apparatus (ACS-4000, manufactured by ULVAC, Inc.), and the intermediate layer 48 was formed on the n-type semiconductor layer 47 at 25°C using an oxide of magnesium-oxide of zinc sputtering target (manufactured by Furuuchi Chemical Corporation) containing MgO and ZnO in a molar ratio (MgO:ZnO) of 1:2 using Ar as a sputtering gas. The substrate temperature (the surface temperature of the second n-type semiconductor layer on which the intermediate layer 48 is formed) at the time of sputtering was set as shown in Table 2. In addition, the intermediate layer 48 was formed so as to have a thickness of the value shown in Table 2.

Next, the substrate 41 on which the above-described layers were formed was placed in an EB vapor deposition apparatus (manufactured by ULVAC, Inc.) together with an area mask, and an Al layer as a reflective electrode layer (anode) 49 and a Ti layer as a supplemental electrode layer 51 were formed on the intermediate layer 48 in this order. In addition, an electrode layer 52 (cathode) having a stacked structure "Ti/AI/Ti/Pt/Au/AI (1 nm/300 nm/50 nm/100 nm/240 nm/10 nm)" was formed in an area where the emitting layer 44 was not provided on the n-type contact layer 43. The thickness of the electrode layer 52 is 701 nm.

The emitting device was obtained as described above. The configuration of each layer constituting the emitting device is shown in Table 1. In Table 1, the intermediate layer 48, the reflective electrode layer 49, the auxiliary electrode layer 51, and the electrode layer 52 are omitted.

**Table 1**

| | | material | Al composition [at%] | Thickness [nm] | Si conc. [cm⁻³] | Mg conc. [cm⁻³] |
|---|---|---|---|---|---|---|
| n-type semiconductor layer | 2nd layer | AlGaN | 60 | 209∼275 | 2.0×10¹⁹ | - |
| | 1st layer | AlGaN | 60 | 40 | 2.0×10²⁰ | - |
| p-type semiconductor layer | 2nd layer | AlGaN | 50∼60 | 50 | - | 2.0×10²⁰ |
| | 1st layer | AlGaN | 50∼60 | 50 | - | 8.7×10¹⁹ |
| Electron-blocking layer | | AlGaN | 85 | 25 | - | 2.1×10²⁰ |
| Emitting layer | Barrier layer | AlGaN | 55 | 5.5 | 5.0×10¹⁸ | - |
| | Well layer | AlGaN | 40 | 2.5 | 9.0×10¹⁸ | - |
| | Barrier layer | AlGaN | 55 | 11 | 9.0×10¹⁸ | - |
| | Well layer | AlGaN | 40 | 2.5 | 9.0×10¹⁸ | - |
| | Barrier layer | AlGaN | 55 | 11 | 9.0×10¹⁸ | - |
| n-type contact layer | | AlGaN | 60 | 1000 | 2.0×10¹⁹ | - |
| Buffer layer | 2nd layer | AlN | - | 2700 | - | - |
| | 1st layer | AlN | - | 300 | - | - |
| | Core layer | AlN | - | 10 | - | - |
| Substrate | | Sapphire | - | 200µm | | - |

### (Comparative Example 1)

An emitting device was obtained in the same manner as in Example 1, except that the formation of the intermediate layer 48 was omitted and the reflective electrode layer 49 and the auxiliary electrode layer 51 were formed directly on the second n-type semiconductor layer.

The obtained emitting devices were evaluated as follows. Evaluation results are shown in Table 2.

### (1) Reflectance [%]

The sample was irradiated with light at 8 degrees using an integrating sphere attachment device for UV-VIS measuring device, and the diffuse reflection light and the specular reflection light were measured. The measurement wavelength was 284 nm.

### (2) Vf [V]

IV measurement was performed using a semiconductor parameter analyzer apparatus to measure the voltage Vf [V] when the current was 350 mA.

### (3) Output [mW]

The output [mW] at the current 350 mA was measured by the integrating sphere.

**Table 2**

| | Thickness of intermediate layer [nm] | Sputtering temperature [°C] | Reflectance [%] | Vf [V] | Output [mW] |
|---|---|---|---|---|---|
| Example 1 | 16 | 150 | 69.3 | 10.3 | 46.6 |
| Example 2 | 25 | 150 | 39 | 12 | >30 |
| Example 3 | 41 | 150 | 30 | 15 | >30 |
| Example 4 | 16 | 200 | 65 | 12 | >30 |
| Example 5 | 16 | 250 | 65 | 12 | >30 |
| Example 6 | 16 | 275 | 65 | 12 | >30 |
| Comp. Ex. 1 | - | - | 16.5 | 10 | 26 |

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the present application claims Paris convention priority are incorporated herein by reference in its entirety.

## Claims

1. A stacked body, comprising
a reflective electrode layer,
an intermediate layer having a MgZnO composition, and
a semiconductor layer having an AlGaN composition in this order.

2. The stacked body according to claim 1, wherein the reflective electrode layer comprises at least one metal selected from the group consisting of Al, Rh, Mo, W, and Cr.

3. The stacked body according to claim 1 or 2, wherein the intermediate layer comprises an oxide of magnesium and an oxide of zinc.

4. The stacked body according to any one of claims 1 to 3, wherein the intermediate layer has a MgZnO composition of MgₓZn_{y}O (x is 0.2 to 0.8, y is 0.8 to 0.2).

5. The stacked body according to any one of claims 1 to 4, wherein the thickness of the intermediate layer is 1 to 80 nm.

6. A method of producing the stacked body according to any of claims 1 to 5, comprising depositing the intermediate layer on the semiconductor layer.

7. The method of producing according to claim 6, wherein the intermediate layer is formed by sputtering, molecular beam epitaxy (MBE) method, vacuum-deposition, or ion plating.

8. The method of producing according to claim 6 or 7, wherein the surface temperature of the semiconductor layer at the time of forming the intermediate layer is 20°C or higher and 600°C or lower.

9. The method of producing according to any one of claims 6 to 8, wherein the surface temperature of the semiconductor layer at the time of forming the intermediate layer is 180°C or higher and 300°C or lower.

10. The method of producing according to any one of claims 6 to 9, comprising heat-treating the formed intermediate layer at the temperature of 600°C or higher.

11. An emitting device comprising the stacked body according to any one of claims 1 to 5.

12. The emitting device according to claim 11, comprising
a stacked structure having a substrate, an n-type contact layer, an emitting layer, and the stacked body in this order, and
an electrode layer formed on a part of the n-type contact layer on which the emitting layer is not formed.

13. The emitting device according to claim 11, comprising
a stacked structure having a substrate, an n-type contact layer, an emitting layer, a p-type semiconductor layer, and an electrode layer in this order, and
an intermediate layer having a MgZnO composition, and a reflective electrode layer on a part of the n-type contact layer on which the emitting layer is not formed in this order, wherein the part of the n-type contact layer, the intermediate layer having a MgZnO composition, and the reflective electrode layer form the stacked body.

14. The emitting device according to claim 11, comprising
a stacked structure having a substrate, an n-type contact layer, an emitting layer, and the stacked body in this order, and
an intermediate layer having a MgZnO composition and a reflective electrode layer on a part of the n-type contact layer on which the emitting layer is not formed in this order, wherein the part of the n-type contact layer, the intermediate layer having a MgZnO composition, and the reflective electrode layer form the stacked body.

15. The emitting device according to any one of claims 12 to 14, comprising a p-type semiconductor layer between the emitting layer and the stacked body, wherein the p-type semiconductor layer and the semiconductor layer of the stacked body form a tunnel junction structure.
